# EUROPÄISCHE PATENTANMELDUNG

(11) **EP 4 741 527 A1**
(43) Veröffentlichungstag der Anmeldung: **13.05.2026**
(21) Anmeldenummer: 25209501.3
(22) Anmeldetag: 17.10.2025
(51) Int. Cl.: C23C 16/02, C23C 16/04, C23C 16/26, C23C 16/27, C23C 16/458

(54) **MIT DIAMANT BESCHICHTETES AIN-SUBSTRAT UND VERFAHREN ZUM HERSTELLEN**

(30) Priorität: 21.10.2024 DE 102024130537
(71) Anmelder: CONDIAS GMBH, 25524 Itzehoe (DE)
(72) Erfinder: Cymann, Benjamin, Itzehoe (DE); Graßl, Tobias, Hohenaspe (DE); Mathiak, Dirk, Itzehoe (DE); Matthée, Thorsten, Hohenaspe (DE); Neuber, Rieke, Halstenbek (DE)
(74) Vertreter: Gramm, Lins & Partner Patent- und Rechtsanwälte PartGmbB

(57) **Zusammenfassung**

Die Erfindung betrifft eine Vorrichtung mit einem Substrat (2) aus Aluminium-Nitrid, das eine Oberseite (4) und einer der Oberseite (4) gegenüberliegende Unterseite (6) aufweist, wobei die Oberseite (4) mit einer Diamantschicht (8) beschichtet ist, die **dadurch gekennzeichnet** ist, **dass** ein beschichteter Bereich der Unterseite (6) eine kohlenstoffhaltige Beschichtung (10) aufweist, die wenigstens 50 % sp2-konfigurierten Kohlenstoff enthält, und ein freier Bereich (12) der Unterseite (6) eine dünnere kohlenstoffhaltige Beschichtung (10) aufweist als der beschichtete Bereich, wobei unabhängig vom Dickenprofil der kohlenstoffhaltigen Beschichtung im beschichteten Bereich der Unterseite die Dicke der Beschichtung (10) im freien Bereich (12) geringer als in dem diesen freien Bereich (12) direkt umgebenden oder direkt an ihn angrenzenden Teil des beschichteten Bereiches, wobei der freie Bereich (12) höchstens 10 %, der Unterseite (6) des Substrates (2) bildet.

## Beschreibung

Die Erfindung betrifft eine Vorrichtung mit einem Substrat aus Aluminium-Nitrid (AIN), das eine Oberseite und einer der Oberseite gegenüberliegende Unterseite aufweist, wobei die Oberfläche mit einer Diamantschicht beschichtet ist. Die Erfindung betrifft zudem ein Verfahren zum Beschichten einer Oberfläche eines Substrates aus Aluminium-Nitrid mit einer Diamantschicht in einem CVD-Reaktor.

Aus dem Stand der Technik ist es bekannt, eine Diamantschicht auf ein Substrat aufzubringen, um die oftmals vorteilhaften Eigenschaften des Diamanten nutzen zu können. So werden beispielsweise Elektroden für elektrochemische Zellen mit einer dotierten Diamantschicht beschichtet, um auszunutzen, dass die Diamantschicht chemisch inert und mechanisch und thermisch sehr stabil ist, wobei die Dotierung notwendig ist, um die Leitfähigkeit der ansonsten elektrisch isolierenden Diamantschicht zu erhöhen. In anderen Anwendungen werden die mechanische Härte und Beständigkeit des Diamanten ausgenutzt.

Um eine Diamantschicht auf ein Substrat, beispielsweise einen Silizium-Einkristall, aufzubringen, wird häufig ein CVD-Reaktor verwendet. Dabei steht CVD für "chemical vapor deposition". Das CVD-Verfahren ist aus dem Stand der Technik seit langem bekannt. Der für die Bildung der Diamantschicht notwendige Kohlenstoff wird aus in den Reaktor eingeleitetem Methan gewonnen. Die Herausforderung besteht darin, die Prozessparameter so zu wählen, dass tatsächlich eine Diamantschicht und keine andere mögliche Kohlenstoffschicht abgeschieden wird. Wird als Substrat ein Einkristall verwendet, beispielsweise aus Silizium, ist die Haftung der abgeschiedenen Diamantschicht in der Regel groß genug, um das so beschichtete Substrat für die jeweilige Anwendung zu benutzen. Ein beidseitig mit einer Diamantschicht beschichtetes Substrat, das als Elektrode für elektrochemische Anwendungen vorgesehen ist, ist aus der DE 10 2021 110 587 A1 bekannt. Die Art und Qualität der abgeschiedenen Diamantschicht ist von einer Reihe von Parametern abhängig, die möglichst genau einzustellen sind. Dies wird beispielsweise für die Temperatur in der DE 696 29 980 T beleuchtet.

Im Stand der Technik wurde versucht, auch Aluminium-Nitrid-Substrate, also ein aus einer Keramik hergestellte Substrat, mit einer Diamantschicht zu beschichten und dabei das CVD-Verfahren zu nutzen. Dies ist beispielsweise der DE 197 10 202 A1 und der CN 1 13 755 819 A zu entnehmen. Dies führte jedoch zu einer schlechteren Haftung der abgeschiedenen Diamantschicht auf dem Substrat als erwartet und als erforderlich. Bei einem Aluminium-Nitrid-Substrat im Sinne der vorliegenden Erfindung handelt es sich um eine Aluminium-Nitrid-Keramik, die zusätzlich Zuschlagstoffe enthalten kann, die bei der Herstellung der Keramik verwendet werden, um chemische, thermische und/oder mechanische Eigenschaften der Keramik, die oftmals einem Sinterprozess unterzogen wird, zu beeinflussen.

Die Beschichtung einer Aluminium-Nitrid-Keramik stellt sich daher aus mehreren Gründen als schwierig dar. Ein Problem können metallische Aluminium-Reste, also mehr oder weniger große Bereiche aus metallischem Aluminium, sein, die bei den hohen Temperaturen, die beim CVD-Beschichten herrschen schmelzen können. Aluminium weist eine Schmelztemperatur von etwa 660 °C auf. In einem CVD-Reaktor herrschen Temperaturen bis zu 900 °C, sodass metallisches Aluminium schmilzt. Das Substrat wird an den Stellen, an denen metallisches Aluminium an der Oberfläche vorliegt, verflüssigt und kann daher nicht mehr mit einer Diamantschicht beaufschlagt werden. Aufgrund des hohen Dampfdruckes des Aluminiums kann zudem ein nennenswerter Anteil des Aluminiums in den gasförmigen Zustand übergehen und so sowohl die aus der Gas-Atmosphäre, die im CVD-Reaktor herrscht, abgeschiedene Beschichtung als auch den Reaktor selbst stark verunreinigen, sodass er nur nach einer aufwendigen, zeitintensiven und teuren Grundreinigung wieder verwendbar ist.

Ein anderes Problem können die oft nicht bekannten Zuschlagstoffe, beispielsweise Y₂O₃ sein, die der Keramik beigefügt sind. Da oftmals weder deren Zusammensetzung noch deren Schmelzpunkte, Siedepunkte oder Gasdrücke bekannt sind, ist kaum vorherzusagen, wie die Zuschlagstoffe sich beim Beschichten der Oberfläche des Substrates verhalten und ob sie überhaupt einer Beschichtung standhalten oder für sie geeignet sind.

Eine weitere Schwierigkeit besteht darin, dass das Aluminium-Nitrid des Substrates und die aufzubringende Diamantschicht sehr unterschiedliche kristallographische Eigenschaften haben. Das Aluminium-Nitrid liegt als polykristalline Keramik vor, wobei der Aluminium-Nitrid-Kristall ein hdp-Gitter aufweist. Die Abkürzung hdp steht dabei für "hexagonal dichteste Packung". Die Diamantschicht wächst hingegen in einem kubischen Kristallgitter auf, wobei die (1 1 1)-Ebene dieses kubischen Gitters eine große Fehl-Passung zu dem hgp-Gitter aufweist.

Der Erfindung liegt die Aufgabe zugrunde, eine Vorrichtung gemäß dem Oberbegriff des Anspruchs 1 zu verbessern und ein Verfahren vorzuschlagen, mit dem eine Oberfläche eines Aluminium-Nitrid-Substrates mit einer Diamantschicht in einem CVD-Reaktor beschichtet werden kann.

Die Erfindung löst die gestellte Aufgabe durch eine Vorrichtung mit einem Substrat aus Aluminium-Nitrid, das eine Oberseite und eine der Oberseite gegenüberliegende Unterseite aufweist, wobei die Oberseite mit einer Diamantschicht beschichtet ist, wobei sich die Vorrichtung dadurch auszeichnet, dass ein beschichteter Bereich der Unterseite eine kohlenstoffhaltige Beschichtung aufweist, die wenigstens 50 % sp2-konfigurierten Kohlenstoff enthält, und ein freier Bereich der Unterseite eine dünnere kohlenstoffhaltige Beschichtung aufweist als der beschichtete Bereich, wobei unabhängig vom Dickenprofil der kohlenstoffhaltigen Beschichtung im beschichteten Bereich der Unterseite die Dicke der Beschichtung im freien Bereich geringer als in dem diesen freien Bereich direkt umgebenden oder direkt an ihn angrenzenden Teil des beschichteten Bereiches, wobei der freie Bereich höchstens 10 %, der Unterseite des Substrates bildet.

Die kohlenstoffhaltige Beschichtung, die sich auf der Unterseite des Substrates befindet, weist eine Dicke auf, die nicht konstant sein muss. Vorzugsweise nimmt die Dicke der Beschichtung im beschichteten Bereich mit steigendem Abstand vom Rand der Unterseite des Substrates ab. Die Dicke der Beschichtung kann im beschichteten Bereich auch konstant ausgebildet sein. Auch im freien Bereich der Unterseite des Substrates kann eine kohlenstoffhaltige Beschichtung vorhanden sein. Der Begriff "freier Bereich" ist daher nicht so zu verstehen, dass dieser Bereich frei von jeglicher Beschichtung sein muss. Die in diesem freien Bereich vorhandene Beschichtung ist weist jedoch eine geringere Dicke auf als die kohlenstoffhaltige Beschichtung im beschichteten Bereich der Unterseite des Substrates. Unabhängig vom Dickenprofil der kohlenstoffhaltigen Beschichtung im beschichteten Bereich der Unterseite ist die Dicke der in-situ abgeschiedenen Beschichtung im freien Bereich der Unterseite geringer als in dem diesen freien Bereich direkt umgebenden oder direkt an ihn angrenzenden Teil des beschichteten Bereiches. Dies bedeutet nicht zwangsläufig, dass die Dicke der kohlenstoffhaltigen Beschichtung an jeder Stelle des beschichteten Bereiches größer als die Dicke an jeder Stelle des freien Bereiches, auch wenn das eine bevorzugte Ausgestaltung ist. Es ist durchaus möglich, dass die Dicke der Beschichtung in einem freien Bereich größer ist als die Dicke an einer Stelle des beschichteten Bereiches. Dies ist beispielsweise möglich, wenn der freie Bereich nach am Rand der Unterseite des Substrates liegt und die Stelle des beschichteten Bereiches weit von dem Rand der Unterseite entfernt ist.

Vorzugsweise weist die kohlenstoffhaltige Beschichtung an der Grenze zwischen dem beschichteten Bereich und dem freien Bereich eine Stufe auf. Eine Stufe ist dabei insbesondere ein Bereich, in dem die Ableitung der Dicke nach dem Ort einen deutlich größeren Wert annimmt als an anderen Stellen der Unterseite.

Vorzugsweise weist der freie Bereich keine kohlenstoffhaltige Beschichtung auf. Die Dicke der Beschichtung ist in diesem Bereich dann Null.

Die kohlenstoffhaltige Beschichtung an der Unterseite erstreckt sich vorzugsweise auch an der Seitenfläche des Substrates, die die Oberseite mit der Unterseite verbindet. Die Dicke der kohlenstoffhaltigen Beschichtung an der Seitenfläche des Substrates nimmt vorzugsweise von der Oberseite ausgehend in Richtung auf die Unterseite des Substrates ab.

Die kohlenstoffhaltige Beschichtung an der Unterseite des Substrates und gegebenenfalls auch an der Seitenfläche des Substrates wird im gleichen Beschichtungsschritt wie die Diamantschicht an der Oberseite des Substrates aufgebracht. Um die kohlenstoffhaltige Beschichtung auf die Unterseite des Substrates aufzubringen, darf die Unterseite nicht vollflächig auf einem Probentisch aufliegen, sondern muss mit der Gasatmosphäre innerhalb des Beschichtungsreaktors, der beispielsweise ein CVD-Reaktor ist, in Kontakt kommen können. Um dies zu erreichen ist es von Vorteil, das Substrat auf einer oder mehreren Stützen zu lagern, so dass zwischen der Unterseite des Substrates und dem Probentisch ein Zwischenraum vorhanden ist, in den die Gasatmosphäre eindringen kann. Das Substrat weist an der Unterseite in der Regel eine Temperatur auf, die oftmals nicht ausreicht, um eine Diamantschicht abzuscheiden, die aber hoch genug ist, damit sich ein anderes kohlenstoffhaltiges Material bildet.

An den Stellen, wo die Unterseite des Substrates auf der wenigstens einen Stütze aufliegt, kommt die Gasatmosphäre nicht oder nur wenig mit der Unterseite des Substrates in Kontakt, so dass sich an diesen Stellen zumindest ein Teil des freien Bereiches befindet, an dem nur eine dünnere oder sogar keine kohlenstoffhaltige Beschichtung an der Unterseite des Substrates vorliegt.

Der Erfindung liegt die Erkenntnis zugrunde, dass die Haftung der Diamantschicht auf der Oberseite des Substrates verbessert wird, wenn sich an der Unterseite des Substrates in einem beschichteten Bereich die kohlenstoffhaltige Beschichtung befindet und wenigstens ein freier Bereich vorhanden ist, in dem nur eine dünnere oder sogar keine derartige Beschichtung vorhanden ist.

Vorzugsweise erstreckt sich der freie Bereich ringförmig, besonders bevorzugt kreisringförmig oder polygonal. Vorzugsweise ist der freie Bereich aus einer Mehrzahl voneinander getrennter Teilbereiche gebildet. Jeder dieser Teilbereiche kann kreisförmig, oval oder polygonal ausgebildet sein oder eine andere freie Form aufweisen. Die verschiedenen Teilbereiche sind können die gleiche Form und/oder die gleiche Größe aufweisen. Die verschiedenen Teilbereiche können unterschiedliche Formen und/oder unterschiedliche Größen aufweisen. In einer bevorzugten Ausgestaltung erstrecken sich einige dieser Teilbericht teilringförmig und bilden gemeinsam einen durchbrochenen ringförmigen freien Bereich, bevorzugt einen durchbrochenen kreisringfömigen oder polygonalen freien Bereich.

In bevorzugten Ausgestaltungen bildet der freie Bereich höchstens 6 %, besonders bevorzugt höchstens 3 % der Unterseite des Substrates.

Vorzugsweise weist die Oberseite des Substrates wenigstens ein Strukturelement, insbesondere wenigstens eine Erhöhung und/oder wenigstens eine Vertiefung auf. Bevorzugt weist die Unterseite des Substrates wenigstens ein Strukturelement, insbesondere eine Erhöhung und/oder wenigstens eine Vertiefung auf. Eine solche Erhöhung oder Vertiefung weist bevorzugt eine Höhe oder Tiefe von wenigstens 1 mm, vorzugsweise mindestens 2 mm und höchstens 10 mm, bevorzugt höchstens 8 mm auf.

Vorteilhafterweise liegt wenigstens ein Strukturelement der Unterseite in dem Bereich der Unterseite, der nur eine dünnere oder sogar keine kohlenstoffhaltige Beschichtung aufweist. Besonders bevorzugt liegen alle Strukturelemente der Unterseite in dem Bereich der Unterseite, der nur eine dünnere oder sogar keine kohlenstoffhaltige Beschichtung aufweist.

Vorzugsweise ist wenigstens ein Strukturelement, das an der Unterseite oder der Oberseite des Substrates vorhanden ist, eine Vertiefung, in die in einem späteren Fertigungsschritt ein elektronisches Bauteil, beispielsweise ein Sensor, eingesetzt werden soll. Alternativ oder zusätzlich dazu ist wenigstens ein Strukturelement ein Graben oder eine Nut, in die in einem späteren Verfahrensschritt elektrische Leitungen oder Signalleitungen eingelegt werden sollen. Daher ist es von Vorteil, wenn diese Strukturelemente nicht von einer kohlenstoffhaltigen Beschichtung überdeckt sind.

Vorzugsweise enthält die Diamantbeschichtung an der Oberseite des Substrates weniger als 5 %, vorzugsweise weniger als 3 %, besonders bevorzugt weniger als 1 % sp2-konfigurierten Kohlenstoff.

Die kohlenstoffhaltige Beschichtung weist einen Anteil sp2-konfigurierten Kohlestoff auf. Vorzugsweise enthält die kohlenstoffhaltige Beschichtung an der Unterseite des Substrates wenigstens 70 %, besonders bevorzugt wenigstens 90 % sp2-konfigurierten Kohlenstoff. Die kohlenstoffhaltige Beschichtung kann teilweise eine Diamantbeschichtung und/oder eine diamantartige Beschichtung (diamond-like coating DLC) sein. Vorzugsweise ist der zu 100 % fehlende Anteil der kohlenstoffhaltigen Beschichtung eine Diamantbeschichtung und/oder eine diamantartige Beschichtung.

Vorzugsweise weist die Vorrichtung zwischen dem Aluminium-Nitrid des Substrates und der Diamantschicht auf der Oberseite des Substrates Aluminiumcarbonitrid (Summenformel AlCN) auf.

Vorzugsweise ist die Diamantschicht an der Oberseite des Substrates dotiert, wobei die Dotierung vorzugsweise Bor und/oder Phosphor und/oder Stickstoff enthält.

In einer bevorzugten Ausgestaltung weist die Diamantschicht eine homogene Dicke auf. Dies ist beispielsweise dann der Fall, wenn die Diamantschicht an der dicksten Stelle der Diamantschicht maximal 2 µm, bevorzugt maximal 1 µm, besonders bevorzugt maximal 0,2 µm dicker als an der dünnsten Stelle der Diamantschicht ist.

In bevorzugten Ausgestaltungen weist auch die Unterseite des Substrates eine Diamantbeschichtung auf, auf der und/oder unter der die kohlenstoffhaltige Beschichtung angeordnet ist. Diese Ausgestaltung lässt sich beispielsweise herstellen, indem in einem ersten Beschichtungsschritt die Diamantschicht auf die Oberseite des Substrates und gleichzeitig die kohlenstoffhaltige Beschichtung auf die Unterseite des Substrates abgeschieden wird. Das Substrat wird dann umgedreht, so dass die mit Diamant beschichtete Oberseite unten ist. In dieser Position wird ein zweiter Beschichtungsschritt ausgeführt, in dem nun die Unterseite mit einer Diamantschicht versehen wird. Bei der Beschichtung der Unterseite mit Diamant wird die Schichtdicke der auf der Unterseite vorher abgeschiedenen kohlenstoffhaltigen Beschichtung durch die Diamantbeschichtung reduziert

Alternativ dazu kann auch im ersten Beschichtungsschritt die Unterseite des Substrates mit einer Diamantschicht beschichtet werden. Dazu wird das Substrat mit der Unterseite nach oben in den Reaktor eingebracht. Nachdem die Diamantschicht auf der Unterseite des Substrates aufgebracht wurde, wird das Substrat umgedreht und mit der Oberseite nach oben erneut beschichtet. In diesem zweiten Beschichtungsschritt wird die Diamantschicht auf der Oberseite des Substrates und gleichzeitig die kohlenstoffhaltige Beschichtung auf der Unterseite des Substrates erzeugt. Diese wird daher auf der Diamantschicht abgeschieden und befindet sich somit auf der Diamantschicht.

Die Erfindung löst die gestellte Aufgabe durch ein Verfahren zum Beschichten einer Oberfläche eines Substrates aus Aluminium-Nitrid mit einer Diamantschicht in einem CVD-Reaktor, dass folgende Schritte aufweist:
a. Ätzen der Oberfläche außerhalb des Reaktors mit einem Ätzmittel, sodass eine vorbereitete Oberfläche entsteht,
b. Bekeimen der vorbereiteten Oberfläche mit Diamantpartikeln,
c. Positionieren des Substrates mit der bekeimten Oberfläche auf einem Probentisch, wobei das Substrat auf wenigstens einer Stütze gelagert ist,
d. Positionieren des Probentisches mit dem Substrat in dem Reaktor,
e. Aufheizen des Reaktors und des Substrates auf einer Betriebstemperatur und
f. Abscheiden der Diamantschicht auf die Oberfläche und einer kohlenstoffhaltigen Beschichtung, die wenigstens 50 % sp2-konfigurierten Kohlenstoff enthält, auf einer Unterseite des Substrates.

In einem ersten Schritt wird die Oberfläche, die mit der Diamantschicht beschichtet werden soll, außerhalb des Reaktors geätzt. Dabei werden beispielsweise chemische Ätzmittel verwendet, um Verunreinigungen von der Oberfläche zu entfernen. Vorzugsweise werden dadurch wenigstens 90 %, bevorzugt wenigstens 95 %, besonders bevorzugt 100 % der auf der Oberfläche vorhandenen Verschmutzungen, insbesondere der organischen und/oder metallischen Kontaminationen der Oberfläche entfernt. Die so behandelte Oberfläche ist für die Bekeimung vorbereitet und wird daher vorbereitete Oberfläche genannt.

Die vorbereitete Oberfläche wird mit Diamantpartikeln bekeimt. Das Bekeimen der Oberfläche eines Substrates ist aus dem Stand der Technik prinzipiell bekannt. Dazu wird beispielsweise eine Suspension vorbereitet, in der mikrokristalline und/oder nanokristalline Diamantpartikel enthalten sind. Diese wird auf die mit der Diamantschicht zu Beschichten der Oberfläche aufgebracht.

Das Substrat wird nach dem Bekeimen auf einem Probentisch positioniert. Der Probentisch wird dann mit dem darauf positionierten Substrat in dem Reaktor positioniert. Dabei kommt der exakten Positionierung große Bedeutung zu. Um die Probleme mit gegebenenfalls vorhandenem metallischem Aluminium oder anderen Zuschlagstoffen möglichst gering zu halten, ist es von Vorteil, wenn die Diamantschicht möglichst schnell auf die zu Beschichten der Oberfläche aufwächst und abgeschieden wird. Dazu ist es von Vorteil, wenn eine möglichst große Fläche der Oberfläche, besonders bevorzugt die gesamte Oberfläche, eine zum Beschichten und Abscheiden der Diamantschicht ausreichende Temperatur aufweist, die durch Filamente im CVD-Reaktor, die durch elektrischen Strom erhitzt werden, erreicht wird. Dazu ist es von großer Wichtigkeit, das Substrat so zu den Filamenten auszurichten, dass möglichst viel der erzeugten Wärme auf einer möglichst großen Fläche der Oberfläche aufgefangen werden kann.

Anschließend wird der Reaktor und das darin angeordnete Substrat auf eine Betriebstemperatur aufgeheizt, die beispielsweise 900 °C betragen kann. Dann wird die Diamantschicht auf die Oberfläche des Substrates abgeschieden.

Vorzugsweise wird in einem weiteren Verfahrensschritt eine Diamantschicht auf der Unterseite des Substrates abgeschieden, wobei das Substrat vorzugsweise zuvor umgedreht wird.

In einer bevorzugten Ausgestaltung ist das Ätzmittel Phosphorsäure (H₃PO₄) oder enthält diese. Dies ist eine kostengünstigere und bezüglich der Arbeitssicherheit deutlich zu bevorzugende Wahl des Ätzmittels als beispielsweise Fluor-Wasserstoff (HF), der auch als Flusssäure bezeichnet wird und ebenfalls als Ätzmittel aus dem Stand der Technik bekannt ist.

Vorzugsweise geschieht das Bekeimen vor dem Positionieren des Substrates in dem Reaktor.

Vorzugsweise wird das Substrat auf mehreren Stützen gelagert auf dem Probentisch positioniert. Das Substrat liegt also nicht, wie aus dem Stand der Technik bekannt, vollflächig auf dem Probentisch auf, sondern ist auf den Stützen gelagert, die dafür sorgen, dass ein Bereich der Unterseite des Substrates mit der Gasatmosphäre innerhalb des Reaktors in Kontakt kommt. Dieser Bereich der Unterseite wird mit der kohlenstoffhaltigen Beschichtung versehen, während die Oberseite mit der Diamantschicht beschichtet wird.

Dadurch wird der thermische Kontakt zu anderen Gegenständen, insbesondere dem Probentisch, deutlich reduziert, was zur Folge hat, dass weniger Wärme vom Substrat in die anderen Gegenstände, insbesondere den Probentisch, abgeleitet werden kann. Die den Stützen abgewandte Oberfläche des Aluminium-Nitrid-Substrates erreicht folglich schneller und länger und homogener und vorzugsweise auch in einem größeren Bereich die für die Abscheidung der Diamantschicht notwendige Temperatur. Dies hat einerseits zur Folge, dass größere Substrate und größere Oberflächen beschichtet werden können und andererseits, dass die Diamantschicht schneller abgeschieden werden kann und somit eine geschlossene Decke über der Oberfläche des Aluminium-Nitrid-Substrates bildet, sodass die durch metallisches Aluminium und/oder unbekannte Zuschlagstoffe der Aluminium-Nitrid-Keramik hervorgerufenen Probleme möglichst schnell behoben werden können. Nachdem die Diamantschicht eine geschlossene Decke auf der Oberfläche des Substrates bildet, wird im weiteren Fortgang der Beschichtung diese Diamantschicht weiter beschichtet und wächst. Darunterliegende Fremdstoffe, Zuschlagstoffe oder metallischen Phasen können die Beschichtung nicht mehr verhindern, aufhalten und/oder beeinflussen.

Vorzugsweise sind wenigstens drei Stützen vorhanden, auf denen das Substrat gelagert wird. Die Positionen der drei oder mehr Stützen bilden vorzugsweise ein gleichseitiges Dreieck oder ein Polygon, das einerseits so groß ausgebildet ist, dass das Substrat sicher auf den Stützen gelagert ist, und andererseits möglichst klein ausgebildet wird, um den Kontaktbereich zwischen den Stützen und der Rückseite des Substrates möglichst nah an der Mitte des Substrates zu positionieren. Die Stützen können auch so ausgeführt sein, dass am Rand der Unterseite positioniert sind. Vorzugsweise sind sie mit den Kanten des Substrats in Kontakt, an der die Unterseite des Substrates mit einer Seitenfläche des Substrates aneinander angrenzen. Die Stützen können auch so ausgeführt sein, dass sie an wenigstens einer Seitenfläche des Substrats angebracht sind und vorzugsweise mit dem Substrat während der Beschichtung fest verbunden sind. Der freie Bereich der Unterseite wird dann durch den Beschichtungsschatten der Stützen gebildet.

Vorzugsweise sind an dem Substrat Erweiterungen angeordnet, die über den Rand der Unterseite des Substrates hervorstehen. In diesem Fall ist es von Vorteil, an diesen Erweiterungen wenigstens einige der Stützen, vorzugsweise alle Stützen, anzuordnen.

Der mittlere Bereich der Oberfläche des Substrates wird durch die Filamente am stärksten erwärmt, sodass hier am ehesten Wärme abfließen kann, ohne dass die Temperatur unter die zum Abscheiden der Diamantschicht benötigte Temperatur fällt. Vorzugsweise sind mehr als 3, beispielsweise wenigstens 6, bevorzugt wenigstens 10, besonders bevorzugt wenigstens 20 Stützen vorhanden, auf denen das Substrat gelagert wird. Je größer die Anzahl der Stützen ist, desto gleichmäßiger können sie verteilt werden, sodass die Abstände zwischen zwei Stützen verkleinert werden können, was eine Durchbiegung des Substrates reduziert und die mechanischen Spannungen, die durch die Lagerung an wenigen Punkten hervorgerufen werden kann, ebenfalls verringert.

Bevorzugt wird ein Umgebungselement auf dem Probentisch positioniert, dass das Substrat in einer Ebene parallel zum Probentisch zumindest teilweise, vorzugsweise jedoch vollständig umgibt. Damit kann dem Effekt entgegengewirkt werden, dass der Randbereich des Substrates überproportional stark beschichtet wird, wenn dort kein Umgebungselement vorhanden ist. Das Umgebungselement verfügt über eine Oberseite, die vorzugsweise mit dem Rand der Oberfläche des Substrates bündig abschließt. Der Rand der Oberfläche ist vorzugsweise die Kante, an der die Oberfläche des Substrates und die Seitenfläche des Substrates aufeinandertreffen. Zwischen dem Rand der Oberfläche des Substrates und dem Umgebungselement befindet sich gegebenenfalls ein Spalt, der vorzugsweise ein umlaufender Spalt ist, wobei dieser Spalt möglichst klein ausgebildet wird, um den Effekt des Umgebungselement des auf die abzuschneiden Diamantschicht zu erhöhen. Vorzugsweise weist dieser Spalt eine Breite von höchstens 2 mm, vorzugsweise höchstens 1 mm auf. Die Oberfläche des Substrates, die mit der Diamantschicht zu Beschichten ist, ist vorteilhafterweise eben ausgebildet, bildet also den Ausschnitt einer ebenen Fläche. In diesem Fall erstreckt sich vorzugsweise auch die Oberseite des Umgebungselement in dieser Ebene.

In bevorzugt Ausgestaltungen des Verfahrens enthält beim Aufheizen des Reaktors eine Atmosphäre in dem Reaktor so wenig Methan, dass die Atmosphäre die vorbereitete Oberfläche ätzt. Dadurch wird einerseits erreicht, dass in diesem Verfahrensschritt noch kein Kohlenstoff und damit auch kein Diamant auf die zu Beschichten der Oberfläche abgeschieden wird. Andererseits wird durch die ätzende Wirkung des atomaren Wasserstoffs der Atmosphäre eine Verunreinigung der Oberfläche beispielswiese durch die Reaktion mit in der Atmosphäre enthaltenen Substanzen und Stoffen verhindert.

Vorzugsweise weist die Oberfläche des Substrates in wenigstens einer Richtung eine Ausdehnung von wenigstens 15 cm, vorzugsweise wenigstens 20 cm, besonders bevorzugt wenigstens 25 cm auf. Vorzugsweise erstreckt sich das Substrat in dieser Richtung nicht mehr als 1 m.

Mithilfe der beigefügten Figuren wird nachfolgend ein Ausführungsbeispiel der vorliegenden Erfindung näher erläutert. Es zeigt:
- Figur 1 -: eine schematische Schnittdarstellung durch eine Vorrichtung gemäß einem Ausführungsbeispiel der vorliegenden Erfindung und
- Figur 2 -: eine schematische Darstellung der Unterseite einer Vorrichtung gemäß einem weiteren Ausführungsbeispiel der vorliegenden Erfindung.

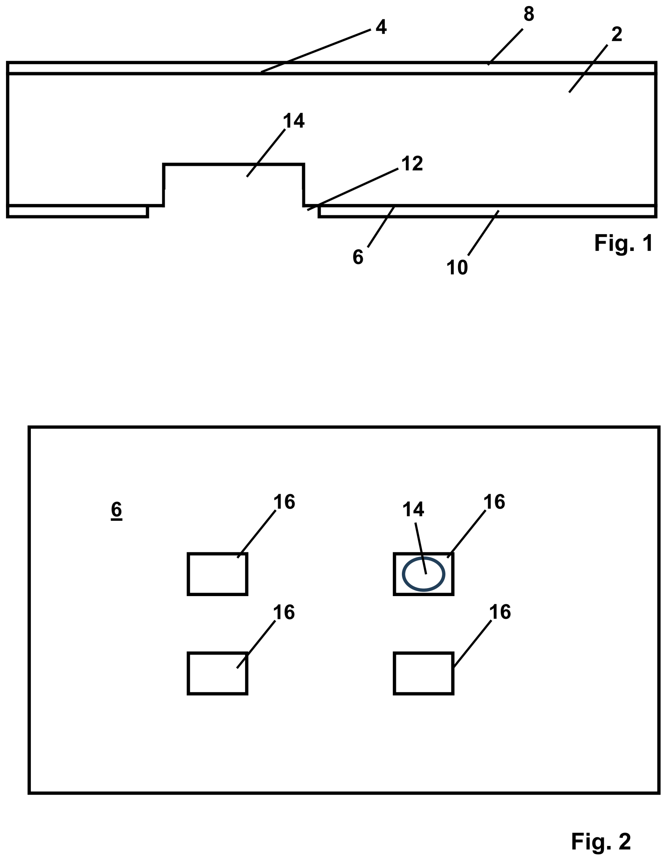

Figur 1 zeigt eine schematische Schnittdarstellung durch eine Vorrichtung gemäß einem Ausführungsbeispiel der vorliegenden Erfindung. Sie verfügt über ein Substrat 2 aus Aluminium-Nitrid, das eine Oberseite 4 und eine Unterseite 6 aufweist. Auf der Oberseite 4 befindet sich eine Diamantschicht 8, die im gezeigten Ausführungsbeispiel die Oberseite 4 des Substrates 2 vollständig überdeckt. Dies ist für alle beschriebenen Ausführungsformen von Vorteil. Auf der Unterseite 6 befindet sich eine kohlenstoffhaltige Beschichtung 10, die jedoch nicht die gesamte Unterseite 6 bedeckt, sondern nur den beschichteten Bereich der Unterseite. Die kohlenstoffhaltige Beschichtung weist eine Lücke auf, die den freien Bereich 12 der Unterseite 6 bildet. Die Unterseite 6 des Substrates 2 weist ein Strukturelement 14 in Form einer Vertiefung auf. Dieses Strukturelement 14 befindet sich im freien Bereich 12 der Unterseite 6 und ist somit nicht von der kohlenstoffhaltigen Beschichtung 10 überdeckt. Dies ist von Vorteil, aber nicht notwendig. Es ist auch möglich, dass ein Strukturelement im beschichteten Bereich der Unterseite 6 angeordnet und dann entsprechend mit der kohlenstoffhaltigen Beschichtung überdeckt ist.

Figur 2 zeigt eine schematische Ansicht einer Unterseite 6 einer Vorrichtung gemäß einem weiteren Ausführungsbeispiel der vorliegenden Erfindung. Die Unterseite weist vier Teilbereiche 16 auf, die jeweils rechteckig ausgebildet sind. Natürlich sind auch andere geometrische Formen möglich. Die Teilbereiche 16 bilden gemeinsam den freien Bereich 12 des Unterseite 6. In dem Teilbereich 16, der oben rechts in Figur 2 dargestellt ist, ist schematisch zudem ein Strukturelement 14 dargestellt, das in Form einer Vertiefung vorliegt.

### Bezugszeichenliste

2 Substrat
4 Oberseite
6 Unterseite
8 Diamantschicht
10 kohlenstoffhaltige Beschichtung
12 freier Bereich
14 Strukturelement
16 Teilbereich

## Patentansprüche

1. Vorrichtung mit einem Substrat (2) aus Aluminium-Nitrid, das eine Oberseite (4) und einer der Oberseite (4) gegenüberliegende Unterseite (6) aufweist, wobei die Oberseite (4) mit einer Diamantschicht (8) beschichtet ist, **dadurch gekennzeichnet, dass** ein beschichteter Bereich der Unterseite (6) eine kohlenstoffhaltige Beschichtung (10) aufweist, die wenigstens 50 % sp2-konfigurierten Kohlenstoff enthält, und ein freier Bereich (12) der Unterseite (6) eine dünnere kohlenstoffhaltige Beschichtung (10) aufweist als der beschichtete Bereich, wobei unabhängig vom Dickenprofil der kohlenstoffhaltigen Beschichtung im beschichteten Bereich der Unterseite die Dicke der Beschichtung (10) im freien Bereich (12) geringer als in dem diesen freien Bereich (12) direkt umgebenden oder direkt an ihn angrenzenden Teil des beschichteten Bereiches, wobei der freie Bereich (12) höchstens 10 %, der Unterseite (6) des Substrates (2) bildet.

2. Vorrichtung nach einem der vorstehenden Ansprüche, **dadurch gekennzeichnet, dass** der freie Bereich (12) sich ringförmig erstreckt.

3. Vorrichtung nach Anspruch 1, **dadurch gekennzeichnet, dass** der freie Bereich (12) aus einer Mehrzahl voneinander getrennter Teilbereiche (16) gebildet ist.

4. Vorrichtung nach einem der vorstehenden Ansprüche, **dadurch gekennzeichnet, dass** der freie Bereich (12) höchstens 6 %, besonders bevorzugt höchstens 3 % der Unterseite (6) des Substrates (2) bildet.

5. Vorrichtung nach einem der vorstehenden Ansprüche, **dadurch gekennzeichnet, dass** die Oberseite (4) des Substrates (2) wenigstens ein Strukturelement (14), insbesondere wenigstens eine Erhöhung und/oder wenigstens eine Vertiefung aufweist.

6. Vorrichtung nach einem der vorstehenden Ansprüche, **dadurch gekennzeichnet, dass** die Unterseite (6) des Substrates (2) wenigstens ein Strukturelement (14), insbesondere eine Erhöhung und/oder wenigstens eine Vertiefung aufweist.

7. Vorrichtung nach Anspruch 6, **dadurch gekennzeichnet, dass** das wenigstens eine Strukturelement (14) der Unterseite (6) in dem freien Bereich (12) der Unterseite (6) liegt.

8. Vorrichtung nach einem der vorstehenden Ansprüche, **dadurch gekennzeichnet, dass** die Diamantbeschichtung (8) an der Oberseite (4) des Substrates (2) weniger als 5 %, vorzugsweise weniger als 3 %, besonders bevorzugt weniger als 1 % sp2-konfigurierten Kohlenstoff enthält.

9. Vorrichtung nach einem der vorstehenden Ansprüche, **dadurch gekennzeichnet, dass** die kohlenstoffhaltige Beschichtung (10) an der Unterseite (6) des Substrates (2) wenigstens 70 %, besonders bevorzugt wenigstens 90% sp2-konfigurierten Kohlenstoff enthält.

10. Vorrichtung nach einem der vorstehenden Ansprüche, **dadurch gekennzeichnet, dass** die Diamantschicht (8) dotiert ist, wobei die Dotierung vorzugsweise Bor und/oder Phosphor und/oder Stickstoff enthält.

11. Vorrichtung nach einem der vorstehenden Ansprüche, **dadurch gekennzeichnet, dass** die Diamantschicht (8) an der dicksten Stelle der Diamantschicht maximal 2 µm, bevorzugt maximal 1 µm, besonders bevorzugt maximal 0,2 µm dicker als an der dünnsten Stelle der Diamantschicht ist.

12. Vorrichtung nach einem der vorstehenden Ansprüche, **dadurch gekennzeichnet, dass** auch die Unterseite (6) des Substrates (2) eine Diamantbeschichtung aufweist, auf der und/oder unter der die kohlenstoffhaltige Beschichtung angeordnet ist.

13. Verfahren zum Beschichten einer Oberseite (4) eines Substrates (2) aus Aluminium-Nitrid mit einer Diamantschicht (8) in einem CVD-Reaktor, wobei das Verfahren folgende Schritte aufweist:
a. Ätzen der Oberseite (4) außerhalb des Reaktors mit einem Ätzmittel, so dass eine vorbereitete Oberseite (4) entsteht,
b. Bekeimen der vorbereiteten Oberseite (4) mit Diamantpartikeln,
c. Positionieren des Substrates mit der bekeimten Oberseite (4) auf einem Probentisch, wobei das Substrat auf wenigstens einer Stütze gelagert ist,
d. Positionieren des Probentisches mit dem Substrat (2) in dem Reaktor,
e. Aufheizen des Reaktors und des Substrates (2) auf eine Betriebstemperatur und
f. Abscheiden der Diamantschicht (8) auf der Oberseite (4) und einer kohlenstoffhaltigen Beschichtung (10), die wenigstens 50 % sp2-konfigurierten Kohlenstoff enthält, auf einer Unterseite (6) des Substrates (2).

14. Verfahren nach Anspruch 13, **dadurch gekennzeichnet, dass** in einem weiteren Verfahrensschritt eine Diamantschicht (8) auf der Unterseite (6) des Substrates (2) abgeschieden wird, wobei das Substrat (2) vorzugsweise zuvor umgedreht wird.
